# EUROPÄISCHE PATENTSCHRIFT

(11) **EP 3 140 856 B1**
(45) Veröffentlichungstag und Bekanntmachung des Hinweises auf die Patenterteilung: **19.02.2020**
(21) Anmeldenummer: 15718477.1
(22) Anmeldetag: 22.04.2015
(51) Int. Cl.: H01L 21/67

(54) **VERFAHREN UND VORRICHTUNG ZUM PERMANENTEN BONDEN**
METHOD AND DEVICE FOR PERMANENT BONDING
PROCÉDÉ ET DISPOSITIF DE LIAISON PERMANENTE

(30) Priorität: 05.05.2014 DE 102014106231
(43) Veröffentlichungstag der Anmeldung: 15.03.2017
(73) Patentinhaber: Ev Group E. Thallner GmbH, 4782 St. Florian am Inn (AT)
(72) Erfinder: WIMPLINGER, Markus, A-4910 Ried im Innkreis (AT); REBHAN, Bernhard, A-4680 Haag a. H. (AT)
(74) Vertreter: Schweiger, Johannes
(86) Internationale Anmeldenummer: PCT/EP2015/058739
(87) Internationale Veröffentlichungsnummer: WO 2015/169603

(56) Entgegenhaltungen:
- EP-A2- 1 339 096
- WO-A1-2013/110315
- DE-A1-102011 080 534
- US-A1- 2011 214 809

## Beschreibung

Die Erfindung betrifft ein Verfahren gemäß Anspruch 1 sowie eine Vorrichtung nach Anspruch 6.

Bei dem, unter dem Namen Waferbonden, bekannten Verfahren werden zwei Substrate, insbesondere Wafer, (insbesondere aus den Materialien Silizium, Quarz oder beliebigen andere Materialien) miteinander verbunden. Man unterscheidet hierbei zunächst zwischen dem temporären Bonden und dem permanenten Bonden. Unter dem temporären Bonden versteht man alle Verfahren, bei denen zwei Substrate, insbesondere zwei Wafer, so miteinander verbunden werden, dass sich das Produktsubstrat stabilisieren und bearbeiten lässt ohne sich vom Trägersubstrat zu lösen, am Ende der Prozesskette allerdings wieder gezielt vom Trägersubstrat entfernt werden kann. Beim Permanentbonden hingegen werden die zwei Substrate, insbesondere Wafer, mit dem Ziel, eine anhaltende, nicht mehr zu lösende Verbindung zu erzeugen, miteinander gebondet. Ein solches Verfahren ist etwa in der WO 2013/110315 A1 beschrieben. Folgende Aufzählung gibt einen Einblick in die Möglichkeiten des Permanentbondens. In der Mikrosystemtechnik kann Waferbonden beispielsweise dazu genutzt werden um einen Wafer mit Kavitäten zu einem mit mikromechanischen und mikrooptischen Bauteilen bestückten zweiten Wafer zu bonden um diese zu schützen. Das Permanentbonden wird auch dazu verwendet, eine permanente Verbindung zwischen Siliziumoberflächen oder Siliziumoxidoberflächen in einem sogenannten Direktbondverfahren herzustellen. Des Weiteren können mit dem Permanentbondingverfahren des Diffusionsbondens oder des eutektischen Bondens auch unzählige Metalloberflächen permanent miteinander verbunden werden. Diese Metallflächen müssen nicht als vollflächige Beschichtung auf den Wafer aufgebracht werden, sondern können aus mehreren, über den ganzen Wafer verteilten, lokal begrenzten Beschichtungen bestehen. Insbesondere können derartige über den ganzen Wafer verteilten, lokal begrenzten Beschichtungen von einem dielektrischen Material, insbesondere Siliziumdioxid umgeben sein. Man nennt derartige Oberflächen dann Hybridoberflächen. Die Hybridoberflächen werden in einem Permanentbondverfahren so zueinander ausgereichtet und miteinander verbondet, dass die elektrisch leitfähigen Metallflächen und die dielektrischen Bereiche miteinander verbonden. Dadurch wird eine Stapelung mehrerer Substrate bei gleichzeitiger Herstellung einer elektrisch leitfähigen Verbindung ermöglicht.

Es gibt also verschiedenartige Methoden des Bondens welche sich neben der eigentlichen Bondmethode auch durch die verschiedenartigen Materialarten der zu verbindenden Wafer unterscheiden. Ein gravierender Nachteil der heute eingesetzten Permanentbondingverfahren für Metalle besteht darin, dass der Bondvorgang nur mit Hilfe von sehr hoher Wärmezufuhr und/oder sehr hohem Druck zu einem befriedigenden Bondergebnis führt. Diese sehr hohe thermische Beanspruchung ist auch unter dem Aspekt des wirtschaftlichen Arbeitens besonders nachteilig und kostenintensiv. Des Weiteren ist die Konstruktion und Produktion von Bondinganlagen, die entsprechend hohe Drücke aufbringen müssen, um die immer größer werdenden Wafer miteinander vollflächig und homogen verbonden zu können, entsprechend schwierig. Die Herstellung entsprechender Bondinganlagen wäre grundsätzlich unproblematisch, wenn man sie beliebig groß konstruieren dürfte. Die Bondinganlagen müssen aber gewisse, insbesondere von der Halbleiterindustrie vorgegebene, Abmessungen aufweisen und müssen daher entsprechend kompakt konstruiert werden.

Neben den genannten Nachteilen eines erhöhten Energiebedarfs reagieren Substratmaterialien auch unterschiedlich auf erhöhte Wärmezufuhr wobei sie eines gemeinsam haben. Eine Wärmezufuhr wirkt sich immer nachteilig auf das verwendete Substratmaterial aus und kann auch zur vollständigen Zerstörung des Substrates und insbesondere der darauf befindlichen Strukturen führen.

Der vorliegenden Erfindung liegt somit die Aufgabe zugrunde, ein Verfahren zu entwickeln, welches es ermöglicht, eine dauerhafte Verbindung von zwei Substratoberflächen, insbesondere zwei Metalloberflächen möglichst ohne die Zuführung von Wärme - idealerweise bei Raumtemperatur - zu realisieren.

Die Oberflächen der miteinander zu bondenden Substrate können erfindungsgemäß aus einem elektrisch leitenden, einem elektrisch nichtleitenden Material bestehen oder Hybrideigenschaften aufweisen. Insbesondere werden erfindungsgemäß unter Bondverfahren solche verstanden, welche dazu benutzt werden, um Hybridoberflächen miteinander zu verbinden. Darunter versteht man, wie bereits erläutert, Oberflächen, die aus mindestens einem leitendem und einem nichtleitendem Material bestehen. Das leitende Material wird dabei gemäß den erfindungsgemäßen Ausführungsformen für den Bondvorgang vorbereitet, während die nichtleitenden Oberflächen nach bekannten Bondmechanismen miteinander gebondet werden können. Um die erfindungsgemäßen Ausführungsformen allerdings an möglichst einfachen Ausführungsformen zu veranschaulichen, wird im weiteren Verlauf des Anmeldetextes mit Vorzug von vollflächigen, sich über das gesamte Substrat erstreckenden, Metalloberflächen gesprochen. Des Weiteren werden in den Figuren ausschließlich vollflächige, sich über das gesamte Substrat erstreckende, Metalloberflächen dargestellt.

Die Erfindung betrifft insbesondere das permanente Cu-Cu-Bonden. Das erfindungsgemäße Verfahren ist grundsätzlich auf alle anderen Materialien und Materialkombinationen übertragbar, in denen mittels der erfindungsgemäßen Ausführungsformen zumindest ein metastabiler Zustand erzeugt werden kann, der vorzugsweise zu einer Rekristallisation des Gefüges führt. Neben dem Bonden von nur zwei Substraten besteht häufig der Wunsch, Substratstapel zu bilden, welche mit dem erfindungsgemäßen Verfahren herstellbar sind. Gerade bei der Herstellung solcher Substratstapel ist es notwendig, eine optimierte Reihenfolge des Zusammenfügens unter Berücksichtigung der Materialart und der vorhandenen Kavitäten zu bestimmen. Mit besonderem Vorzug wird der metastabile Zustand durch eine erhöhte Versetzungsdichte erzeugt. Die erfindungsgemäßen Ausführungsformen sind insbesondere anwendbar auf:
- Metalle, insbesondere
   ∘ Cu, Ag, Au, Al, Fe, Ni, Co, Pt, W, Cr, Pb, Ti, Te, Sn, Zn
- Legierungen,
- Halbleiter (mit entsprechender Dotierung), insbesondere
   ∘ Elementhalbleiter, vorzugsweise
   ▪ Si, Ge, Se, Te, B, α-Sn,
      ∘ Verbindungshalbleiter, vorzugsweise
   ▪ GaAs, GaN, InP, InₓGa₁₋ₓN,InSb, InAs, GaSb, AlN, InN, GaP, BeTe, ZnO, CuInGaSe₂, ZnS, ZnSe, ZnTe, CdS, CdSe, CdTe, Hg(1-x)Cd(x)Te, BeSe, HgS, AlₓGa₁₋ₓAs, GaS, GaSe, GaTe, InS, InSe, InTe, CuInSe₂, CuInS₂, CuInGaS₂, SiC, SiGe.

Vor allem beim Bonden von Substraten mit funktionalen Einheiten wie beispielsweise Mikrochips, Speicherchips oder MEMs sollte der Bondvorgang vorteilhafterweise bei niedrigen Temperaturen durchgeführt werden, um Schädigungen der elektronischen Bauteile auszuschließen bzw. zu minimieren. Des Weiteren wird durch ein Niedertemperaturverfahren auch die Schädigung durch thermische Eigenspannungen auf Grund der Differenz in den thermischen Ausdehnungskoeffizienten unterschiedlicher Materialien weitestgehend a usge schlossen.

Insbesondere werden Substrate, vor allem Substrate mit funktionalen Komponenten wie Mikrochips, Speicherbausteinen, MEMs etc., vor dem eigentlichen Bondprozess zueinander ausgerichtet. Gerade der Ausrichtungsprozess (engl.: alignment) ist bei einem Bondprozess von besonderer Bedeutung da erst eine korrekte Ausrichtung und Kontaktierung die Funktionalität der elektronischen Komponenten sicherstellt. Beim Niedrigtemperaturbonden zweier Wafer aus verschiedenartigen Materialen, die über unterschiedliche Ausdehnungskoeffizienten verfügen, wird das alignment stark vereinfacht, da es keine bzw. nur eine sehr geringe Temperaturdifferenz gibt, die zu einer unterschiedlichen Ausdehnung der beiden, insbesondere aus unterschiedlichen Materialien bestehenden, Substrate führt. Die bei Raumtemperatur durchgeführte Ausrichtungsgenauigkeit bleibt daher beim Niedrigtemperaturbonden erhalten bzw. ändert sich nur sehr wenig. Alignment-beeinflussende Faktoren wie Ausdehnungskoeffizienten können daher weitestgehend vernachlässigt werden. Der Einsatz solch niedriger Temperaturen hat den Nachteil, dass das Bonden ungleich schwerer ist als bei einem Bondverfahren mit höheren Temperaturen (400°C).

Es ist daher die Aufgabe der Erfindung, ein Verfahren und eine dazugehörige Vorrichtung aufzuzeigen, die ein Bonden der Wafer auch bei niedrigen Temperaturen, vorzugsweise bei Raumtemperatur, ermöglicht.

Die Grundidee der Erfindung liegt insbesondere darin, beim Bonden, insbesondere Cu-Cu-Bonden, eine, sich über die Bondgrenzfläche ausbreitende Rekristallisierung zu erreichen. Bei der Rekristallisation kommt es insbesondere zu einem Kornwachstum und/oder einem Gefügeumbau durch Kornneubildung und Ausdehnung der neu gebildeten Korngrenzen. Unter einer Rekristallisierung versteht man also eine Gefügeneubildung durch Kornneubildung und/oder Kornwachstum. Beim Verbonden zweier Substrate erfolgt die Gefügeneubildung mit Vorzug über die Bondgrenzfläche hinweg, sodass ein kontinuierliches Gefüge zwischen den beiden zu verbondenden Substraten, insbesondere den auf den Substraten abgeschiedenen Schichten, entsteht.

Im weiteren Verlauf wird nicht mehr zwischen den Substratoberflächen und den Oberflächen der auf den Substraten abgeschiedenen Schichten unterschieden. Beide Ausdrücke können synonym verwendet werden. Insbesondere können die ersten und/oder zweiten Schichten Bestandteile des ersten und/oder zweiten Substrats sein.

Für eine Rekristallisation in Materialien, insbesondere Metallen, bei moderaten Temperaturen werden erfindungsgemäß Materialien mit einer hohe Versetzungsdichte versehen, erzeugt oder gewählt. Die Versetzungsdichte ist insbesondere größer als 10⁷ cm⁻², vorzugsweise größer als 10⁹ cm⁻², noch bevorzugter größer als 10¹¹ cm⁻², noch bevorzugter größer als 10¹³ cm⁻², am bevorzugter größer als 10¹⁵ cm⁻², am allerbevorzugtesten größer als 1.0¹⁷ cm⁻². Unter einer Versetzung versteht man einen eindimensionalen Gitterdefekt, der entweder bei der Abscheidung eines Materials entstehen oder nachträglich durch plastische Verformung im Kristall erzeugt werden kann. Ein Material mit entsprechend hoher Versetzungsdichte befindet sich insbesondere in einem zumindest metastabilen Zustand und kann durch thermische Aktivierung dazu angehalten werden, durch einen Versetzungsabbau in einen niedrigeren Energiezustand überzugehen. Der Versetzungsabbau erfolgt dabei vorzugsweise durch eine Rekristallisation bei höheren Temperaturen und hat dann einen Gefügeumbau zur Folge. Ein Versetzungsabbau kann erfindungsgemäß alternativ bei niedrigeren Temperaturen durch eine Ausheilung oder Kristallerholung erfolgen. Bei einer Kristallerholung kommt es allerdings nicht zu einem Gefügeumbau durch Rekristallisation sondern ausschließlich zu einer Rekombination der Versetzungen. Dieser Vorgang ist erfindungsgemäß nicht erwünscht und sollte vermieden werden.
Die Erhöhung der Versetzungsdichte erfolgt insbesondere durch erfindungsgemäße Ausführungsformen, bei denen die Versetzung sowohl durch einzelne Impulsschwingungen und/oder anhaltende Schwingungen im Ultraschallbereich erreicht wird. Unter einer einzelnen Impulsschwingung versteht man insbesondere eine im weiteren Verlauf näher beschriebene, einmalige Belastung. Unter einer anhaltenden Schwingung versteht man insbesondere mehrere derartige Belastungen. Die Impulsschwingungen decken insbesondere die gesamte Bandbreite von hochfrequent bis hin zu niederfrequenten Schwingungen ab. Die Frequenz der Schwingungen liegt erfindungsgemäß insbesondere zwischen 1 Hz und 10⁹ Hz, vorzugsweise zwischen 10 Hz und 10⁸, noch bevorzugter 100 Hz und 10⁷, am bevorzugtesten zwischen 10⁴ Hz und 10⁶. Durch eine Kontaktierung der schwingenden, erfindungsgemäßen Ausführungsformen mit den zu bondenden Substraten erfolgt eine hochfrequente, schwingende, mechanische Belastung, welche in den zu bondenden Oberflächen, insbesondere den auf den Substraten abgeschiedenen Materialien, eine entsprechende Versetzungsdichte erzeugt. Durch die Kontaktierung der beiden Substratoberflächen mit einem möglichst niedrigen Druck und einer, mit Vorzug möglichst geringen, Temperatur, erfolgt eine Rekristallisation des Gefüges beim Bondvorgang, insbesondere über die Bondgrenzfläche hinaus.

Um eine Rekristallisation bei möglichst geringen Temperaturen durchführen zu können sollte nicht nur die Versetzungsdichte, sondern auch die Reinheit des rekristalliserenden Materials, möglichst hoch sein. Die Reinheit wird für technische Zwecke optimalerweise in Massenprozent (m%) angegeben. Die Reinheit des Materials ist erfindungsgemäß insbesondere größer als 95 m%, vorzugsweise größer als 99 m%, noch bevorzugter größer als 99,9 m%, am bevorzugtesten größer als 99,99 m%, am allerbevorzugtesten größer als 99,999 m%.

Die Korngröße des rekristallisierenden Gefüges vor der Rekristallisation ist erfindungsgemäß insbesondere kleiner als 1000 nm, vorzugsweise kleiner als 500 nm, noch bevorzugter kleiner als 100 nm, am bevorzugtesten kleiner als 50 nm, am allerbevorzugtesten kleiner als 10 nm. Die Korngröße des rekristallisierenden Gefüges nach der Rekristallisation ist erfindungsgemäß insbesondere größer als 10 nm, vorzugsweise größer als 100 nm, noch bevorzugter größer als 500 nm, am bevorzugtesten größer als 500 nm, am allerbevorzugtesten größer als 1000 nm. In einer ganz besonders bevorzugten Ausführungsform ist die Dicke der durch Rekristallisation gebildeten Körner gleich groß wie die Dicke des rekristallisierten Gefüges.

Um die Mobilität der Atome vor und/oder während und/oder nach der Rekristallisation zu erhöhen besitzt das Gefüge bevorzugt eine möglichst große Punktdefektdichte, insbesondere Leerstellendichte. Eine erhöhte Anzahl an Leerstellen verbessert die Substitutionsdiffusion und trägt damit zu einer verbesserten Verbindung der zwei zu bondenden Oberflächen bei. Die Leerstellendichte ist erfindungsgemäß insbesondere größer als 10⁻¹², vorzugsweise größer als 10⁻¹⁰, noch bevorzugter größer als 10⁻⁸, am bevorzugtesten größer als 10⁻⁶, am allerbevorzugtesten größer als 10⁻⁴. Eine Leerstellendichte von ca. 10⁻⁴ stellt bereits dem typischen Grenzwert der Leerstellendichte für Metalle in der Nähe des Schmelzpunktes dar.

Denkbar ist zudem eine konkave Ausformung eines Probenhalters bzw. eines Unterseitenheizers zum Heizen der Unterseite des Substrats, der ein Durchbiegen/Durchhängen des Wafers im µm-Bereich zulässt. Die konkave Ausformung erlaubt die Durchbiegung des Wafers. Durch diese Durchbiegung kann, insbesondere bei hochfrequenter Beanspruchung des Wafers eine zusätzliche Spannungsbelastung und daher vorteilhafterweise eine Erhöhung der Versetzungsdichte im Wafer, insbesondere in einer Schicht am Wafer, erzeugt werden. Insbesondere erzeugt die Durchbiegung des Wafers im oberflächennahen Bereich des Wafers, der sich näher an der konkaven Ausformung befindet, eine Zugbeanspruchung, während die Oberfläche des Wafers, welche der konkaven Ausformung entgegengesetzt ist, durch eine Druckspannung beansprucht wird. Die, durch die Biegebeanspruchung erzeugten Zug bzw. Druckspannungen nehmen in Richtung der neutralen Linie hin ab. Die Maximalwerte der Zug- bzw. Druckspannung sind insbesondere an den Oberflächen des Wafers zu finden. Auf Grund der geringen Dicke des Wafers sind die durch Biegung erzeugten Zug- bzw. Druckspannungen zwar sehr gering, können allerdings dennoch einen positiven Effekt auf die erfindungsgemäße Ausbildung des metastabilen Zustandes einer der beiden Schichten haben.
Die Bauhöhe einer Druckeinrichtung zur Druckbeaufschlagung des Substratstapels kann insbesondere durch die Verwendung einer Piezotechnik gering gehalten werden und eine Integration in eine erfindungsgemäße Vorrichtung ist somit unproblematisch. Ein solches Verfahren würde, was die Haftfähigkeit der beiden gebondeten Wafer zueinander betrifft, näherungsweise an die heute bekannten Ergebnisse des Hochtemperaturbondens in Bezug auf die Haftfähigkeit heranreichen.

Ein wesentlicher Vorteil besteht darin, dass es zu einer deutlich geringeren Wärmebelastung der auf den Wafern befindlichen und teilweise hochempfindlichen elektronischen Bauteile während des Bondens kommt und somit die Wahrscheinlichkeit irreparabler Schäden weitestgehend ausgeschlossen bzw. erheblich verringert wird. Durch die geringere Bondtemperatur ist auch ein deutlich geringerer Energieverbrauch gegeben. Außerdem wird durch das Niedrigtemperaturbonden ein höherer Durchsatz erreicht, da man auf ein zeitintensives Abkühlen der gebondeten Wafer verzichten kann.

Es ist auch eine Aufgabe der vorliegenden Erfindung zu zeigen, wie es möglich ist, in mikro- und/oder nanometergroßen Strukturen, insbesondere Metallen, eine Erhöhung der Versetzungsdichte zu erzeugen.

Die Versetzungsdichte wird erfindungsgemäß vorwiegend mittels Ultraschall im Gefüge erhöht. Gegenstand der Erfindung ist insbesondere eine Vorrichtung, welche zumindest über eine schwingende Einrichtung verfügt, mit deren Hilfe das Gefüge der miteinander zu bondenden Gebiete in einen metastabilen Energiezustand bringen kann, sodass eine verbesserte Bondwirkung erzielt wird. Insbesondere wird durch die erfindungsgemäßen Ausführungsformen die Versetzungsdichte in den Bereichen mindestens einer der beiden Substrate erhöht. Die erfindungsgemäßen Ausführungsformen können vor und/oder nach der Kontaktierung der Substrate auf die Substratoberflächen angewandt werden. Mit besonderem Vorzug erfolgt eine erfindungsgemäße Erzeugung der Versetzungsdichte erst nach dem Kontaktieren der beiden Substrate zueinander. Erfindungsgemäß denkbar ist aber auch eine Erzeugung der Versetzungsdichte vor dem Kontaktieren oder vor und nach dem Kontaktieren.

Die Vorrichtung verfügt mit Vorzug über ein Thermostat, mit dem die erfindungsgemäße Vorrichtung kontrolliert aufgeheizt werden kann und bei der sich die Bondtemperatur vorteilhafterweise in einem Bereich von Raumtemperatur - bis deutlich unter 300°C bewegt. Das kontrollierte Aufheizen kann alternativ von einer Steuerungstechnik übernommen werden, die in Abhängigkeit des Substratmaterials insbesondere auch andere prozessrelevante Parameter bei den zu benutzenden Rezepten berücksichtigt. Denkbar wäre auch eine Behandlung der zueinander gebondeten Substrate in einem eigenen, externen, von der erfindungsgemäßen Ausführungsform getrennten Ofen. Mit besonderem Vorzug würde es sich dann um einen Durchlaufofen handeln.

Die erfindungsgemäßen Ausführungsformen sind bevorzugt Apparate, welche dazu in der Lage sind, zumindest Teile eines, vorzugsweise des gesamten, Substrats bzw. eines bereits durch einen Prebond miteinander verbundenen Substratstapels, durch eine Schwingung in einen metastabilen Zustand zu bringen. Bei der Schwingung kann es sich erfindungsgemäß um eine Schwingung mit einer einzigen Periode oder mehreren Perioden handeln.

Mit besonderem Vorzug werden die Versetzungserzeugung und der Gefügeumbau direkt durch die erfindungsgemäße Vorrichtung während des Bondvorgangs eingeleitet werden. Dadurch kann verhindert werden, dass ein vor dem Bondvorgang erzeugter metastabile Zustand durch Relaxationsprozesse wieder abgebaut wurde, und während des Bondvorgangs nicht mehr zur Verfügung steht. Denkbar ist natürlich auch die Herstellung eines erfindungsgemäßen metastabilen Zustands in mindestens einem der beiden Substrate vor dem Bondvorgang sowie eine zusätzliche zweite bzw. nachträgliche Erzeugung bzw. Verstärkung eines metastabilen Zustands nach der Kontaktieren, insbesondere während des Bondvorgangs. Insbesondere könnte man erfindungsgemäß von einem Reibschweißvorgang auf Mikro- und/oder Nanoebene sprechen, der durch makroskopische Krafteinleitung bewirkt wird.

Insbesondere besteht ein eigenständiger Aspekt der vorliegenden Erfindung darin, den Substratstapel auf einem Probenhalter zu lagern, der eine Schwingung und/oder Verformung der ersten und/oder zweiten Schicht zulassend ausgebildet ist. Dies kann insbesondere durch, insbesondere ausschließlich an der Peripherie des Probenhalters und/oder des Schwingkörpers angeordnete, Festlager zur Lagerung des Probenhalters und/oder des Schwingkörpers erfolgen.

Vorzugsweisewerden die beiden zu verbindenden Substrate innerhalb einer Ausrichteeinheit (Alignmentmodul) zueinander ausgerichtet. In einem besonderen Ausrichtungsprozess werden die beiden Substrate, insbesondere von der zentrischen Mitte der Substrate hin zu dem radialen Umfang der Substrate, kontaktiert.

Versetzungen werden erfindungsgemäß bevorzugt durch die Einbringung mechanischer Schubspannungen erzeugt. Diese Schubspannungen werden in den Körnern durch eine außen angelegte Spannungsbelastung erzeugt. Die Erzeugung der erfindungsgemäßen Versetzungsdichte kann durch jeder der folgenden erfindungsgemäßen Ausführungsformen entweder vor der Kontaktierung, nach der Kontaktierung, aber vor dem Bonden oder nach der Kontaktierung während des Bondens erfolgen.

In einer ersten erfindungsgemäßen Ausführungsform erfolgt die Erzeugung der Versetzungsdichte durch ein lokal konzentriertes Schwingelement. Bei dieser erfindungsgemäßen Ausführungsform werden Schwingungen durch das Schwingungselement, welches das Substrat bzw. den Substratstapel insbesondere örtlich begrenzt beansprucht erzeugt. Das Schwingungselement kann insbesondere entweder elektrisch, mechanisch, pneumatisch oder hydraulisch angeregt werden. Mit besonderem Vorzug handelt es sich um eine elektrisch erregbare, piezoelektrische Schwingungsvorrichtung. Denkbar und beansprucht wird zudem auch eine mögliche räumliche Trennung des Alignment-Moduls, Schwingungseinrichtung und/oder der zum Ausheizen zu verwendenden Bondkammer. Sofern darstellbar, wird jedoch ausdrücklich auch eine Kombination der vorgenannten Einrichtungen innerhalb eines Clusters beansprucht. Eine Abfolge der einzelnen Verfahrensschritte wird ebenfalls beansprucht. In einer ganz besonders bevorzugten Ausführungsform erfolgt alleine durch das Schwingelement bereits eine Verbondung der beiden Substrate durch Rekristallisation an den Stellen, die durch das Schwingelement bereits beansprucht wurden. In einer weiteren bevorzugten Ausführungsform erhöht das Schwingungselement nur die Versetzungsdichte, ohne zu einer sofortigen Rekristallisation und damit zu einem sofortigen Verbonden zu führen. Der eigentliche Bondvorgang erfolgt dann entweder in einem Ofen und/oder in einer eigenen Bondkammer, in welcher der gesamte Substratstapel nochmals vollflächig mit Druck beaufschlagt und/oder geheizt werden kann.

In weiteren erfindungsgemäßen Ausführungsformen werden das Substrat bzw. der Substratstapel vollflächig in Schwingung, insbesondere in Biegeschwingung und/oder Schwerschwingung, versetzt. Das Substrat bzw. der Substratstapel liegt dabei auf einem Probenhalter auf und wird durch eine Druckplatte oder eine ähnliche erfindungsgemäße Vorrichtung an der zum Probenhalter gegenüberliegenden Seite fixiert, insbesondere mit Druck beansprucht. Danach erfolgt eine erfindungsgemäße, insbesondere lokale und/ oder zumindest nicht die gesamte Oberfläche des Substrats bzw. Substratstapels abdeckende, schwingende Kraftbeanspruchung. Diese Kraftbeanspruchung versetzt das gesamte Substrat bzw. den gesamten Substratstapel in Schwingungen. Dabei sind Probenhalter und/oder Druckplatte insbesondere so ausgelegt, um selbst mitschwingen zu können. Denkbar wäre auch die Verwendung eines stabilen und dicken Probenhalters und einer stabilen Druckplatte, um eine schwingende Scherbeanspruchung des Substrats bzw. des Substratstapels zu erzeugen. Analoge Überlegungen gelten für eine Torsionsbeanspruchung, die allerdings auf Grund der Radialabhängigkeit der Verformung vom Zentrum des Substrats bzw. des Substratstapels nicht die bevorzugte Ausführungsform darstellt.

Erfindungsgemäß beruht die Erzeugung eines metastabilen Gleichgewichts, insbesondere einer an Versetzungen reichen Schicht, auf der Verwendung eines statischen, Probenhalters und/oder einer statischen nicht planaren Druckplatte. Der Probenhalter und/oder die Druckplatte sind dabei vorzugsweise konkav und/oder konvex geformt. In einer besonderen Ausführungsform sind sie aus einem elastischen Material geformt, welches im unbelasteten Zustand zwar eine ebene Oberfläche besitzt, sich unter Druckbelastung aber entsprechend konkav und/oder konvex verformen kann. Durch diese Formmöglichkeit wird der Substratstapel ebenfalls in eine konkave und/oder konvexe Form gezwungen, was zu einer entsprechenden Beanspruchung des Substratstapels und damit der miteinander zu verbondenden Oberflächen führt. Insbesondere erfolgt - im Gegensatz zu den weiter oben bereits genannten erfindungsgemäßen Ausführungsformen - keine dynamische, schwingende, sondern eine rein statische, insbesondere vollflächige Druckbeanspruchung des Substratstapels.

In einer ganz besonderen erfindungsgemäßen Ausführungsform wird die Elastizität des Probenhalters ausgenutzt um den erfindungsgemäßen Aspekt zu erzeugen. Der Probenhalter besitzt eine gewisse Elastizität und ist damit in der Lage, sich unter Druckbelastung zu verformen. Der Probenhalter kann prinzipiell beliebig, vorzugsweise konvex, konkav oder eben, geformt sein. In dieser speziellen erfindungsgemäßen Ausführungsform eignet sich allerdings vor allem ein ebener Probenhalter. Daher wird im weiteren Verlauf des Textes auf einen ebenen Probenhalter Bezug genommen. Durch die Druckbeaufschlagung des elastisch verformbaren, aber vor der elastischen Verformung ebenen Probenhalters, wird eine leicht konkave elastische Verformung bewirkt. Der Probenhalter wird in der Mitte stärker elastisch verformt als am Rand. Die maximale Verformung in eine im Allgemeinen beliebige Richtung, insbesondere aber in Kraftrichtung, ist insbesondere kleiner als 1mm, vorzugsweise kleiner als 100µm, noch bevorzugter kleiner als 10µm am bevorzugtesten kleiner als 1µm, am allerbevorzugtesten kleiner als 100nm. Der E-Modul des Werkstoffs, aus dem der Probenhalter gefertigt wird ist insbesondere größer als 10MPa, vorzugsweise größer als 100MPa, noch bevorzugter größer als 1GPa, am bevorzugtesten größer als 10GPa, am allerbevorzugtesten größer als 100GPa. Der erfindungsgemäße Aspekt einer solchen Ausführungsform besteht insbesondere darin, eine Kraft, insbesondere Flächenkraft, auf den Substratstapel aufzubringen. Durch die Elastizität des Probenhalters wird der Substratstapel quasi in den Probenhalter gedrückt, der minimal, insbesondere konkav, verformt wird. Durch diese extrem leichte Durchbiegung des Substratstapels verschieben sich die beiden, noch nicht miteinander verbondeten, Oberflächen der beiden Substrate latereral, insbesondere entlang ihrer Bondgrenzfläche, leicht zueinander. Durch die dabei entstehende Reibung zwischen den beiden miteinander zu verbondenen Oberflächen erfolgt die erfindungsgemäße Erzeugung des metastabilen Zustands, insbesondere des versetzungsreichen Gefüges. Bei der Entlastung des Substratstapels wird die elastische Energie im Probenhalter dazu genutzt den Probenhalter sowie den Substratstapel wieder in ihre Ausgangsform zu überführen. Dabei findet eine nochmalige, aber in die entgegengesetzte Richtung wirkende Reibung im Substratstapel statt. Dieser Vorgang kann, falls notwendig, beliebig oft wiederholt werden.
In einer weiteren erfindungsgemäßen Ausführungsform ist es denkbar, die Druckbeaufschlagungseinrichtung und/oder den Probenhalter und/oder die gesamte Anlage konstruktionstechnisch derart zu gestalten, dass eine nennenswerte Durchbiegung des Probenhalters und damit auch des zu beanspruchenden Substratstapel erst bei der Belastung erfolgt. Insbesondere wird diese besonders bevorzugte Ausführungsform so realisiert, dass der Probenhalter an seiner Peripherie (vorzugsweise ausschließlich), insbesondere vollumfänglich, durch ein Lager, insbesondere ein Festlager, unterstützt wird, während das Zentrum nicht oder nur nachgiebig unterstützt wird. In dieser speziellen Ausführungsform ist der Probenhalter und damit der Substratstapel im nichtbelasteten Fall, unter Vernachlässigung der Gravitationswirkung und der Fertigungstoleranzen, als eben zu betrachten, biegt sich allerdings unter einer Last, vorzugsweise einer Punktlast entlang der Symmetrieachse des Druckkolbens, noch bevorzugter einer Flächenlast entlang der Druckplatte, in der Mitte konkav durch.

Ein wichtiger erfindungsgemäßer Aspekt ist die Erzeugung eines metastabilen Zustands, insbesondere eines Gefüges mit erhöhter Versetzungsdichte in den Oberflächen zweier miteinander zu verbondener Oberflächen, durch elastische Verformung des Probenhalters und eine dadurch hervorgerufene Reibung zwischen den beiden Oberflächen.

Um die im vorherigen Absatz erwähnten Beanspruchungen durchzuführen, ist die Lagerung des Substrats bzw. des Substratstapels auf unterschiedlichen Probenhaltern denkbar. Die Probenhalter können dabei vollflächig oder nur an deren Peripherie unterstützt sein.

Die Amplituden der Schwingungserreger sind insbesondere kleiner als 100µm, mit Vorzug kleiner als 1µm, mit größerem Vorzug kleiner als 100nm, mit größtem Vorzug kleiner als 10nm.

Die durch die Amplituden erzeugten lateralen, insbesondere zur Substratoberfläche parallelen Verschiebungen können während des erfindungsgemäßen Vorgangs theoretisch beliebige Werte annehmen, solange sie nach Beendigung desselbigen eine bleibenden Ausrichtungsfehler annehmen, der kleiner ist als 100µm, mit Vorzug kleiner als 1µm, mit größerem Vorzug kleiner als 100nm, mit größtem Vorzug kleiner als 10nm. Insbesondere werden die lateralen Verschiebungen kleiner als 10µm, mit Vorzug kleiner als 1µm, mit größerem Vorzug kleiner als 100nm, mit größtem Vorzug kleiner als 10nm eingestellt. Die vertikalen Verschiebungen sind während des erfindungsgemäßen Vorgangs insbesondere kleiner 10µm, mit Vorzug kleiner als 1µm, mit größerem Vorzug kleiner als 100nm, mit größtem Vorzug kleiner als 10nm.

Erfindungsgemäß wird mindestens eine, insbesondere vollflächig am Substrat oder Substratstapel angelegte, Vordruckspannung erzeugt. Die erfindungsgemäßen Vordruckspannungen sind insbesondere größer als 10 N/mm², mit Vorzug größer als 100 N/mm², mit größerem Vorzug größer als 200 N/mm², mit allergrößtem Vorzug größer als 1000 N/mm².

Die Vordruckspannung, bzw. die von-Mises Vergleichsspannung, ist erfindungsgemäß insbesondere größer als die Streckgrenze des Werkstoffes des Substrats bzw. der sich am Substrat befindenden Schicht, die zum Bonden verwendet werden soll., um eine plastische Verformung zu unterstützen, welche die entsprechende Versetzungsbildung zusätzlich begünstigt. Die Streckgrenze des Werkstoffs ist vorzugsweise kleiner als 5000 N/mm², vorzugsweise kleiner als 1000 N/mm², noch bevorzugter kleiner als 750 N/mm², am bevorzugtesten kleiner als 500 N/mm², am allerbevorzugtesten kleiner als 300 N/mm². Die Zugfestigkeit des Werkstoffs ist vorzugsweise kleiner als 5000 N/mm², vorzugsweise kleiner als 1000 N/mm², noch bevorzugter kleiner als 750 N/mm², am bevorzugtesten kleiner als 500 N/mm², am allerbevorzugtesten kleiner als 300 N/mm². Reines, nicht kaltverformtes und daher noch nicht verfestigtes Kupfer besitzt beispielsweise eine Streckgrenze von ca. 70 N/mm² und eine Zugfestigkeit von ca. 200 N/mm².

Durch Überlagerung der schwingenden Beanspruchung mit der Vorspannung werden zusätzliche, zeitlich veränderliche Kräfte erzeugt. Durch die Vorspannung, insbesondere über eine Streckgrenze des Werkstoffes hinaus, ist dieser zumindest mit einer positiven Halbwelle im Fließbereich des Werkstoffes.

Ein weiterer erfindungsgemäßer Effekt, der sich positiv auf die Bondeigenschaften auswirkt, ist die durch die erfindungsgemäßen Vorrichtungen in das System eingebrachte, Wärmeenergie und die damit erreichbare Temperatur. Vor allem in der erfindungsgemäßen Ausführungsform eines lokal konzentrierten Schwingungselements kann eine sehr hohe Wärmedichte und damit eine sehr hohe Temperatur erzeugt werden, durch welche der Bondvorgang lokal initiiert werden kann. Auf eine weitere Wärmebehandlung kann in diesem Fall mit besonderem Vorzug verzichtet werden. Die Rekristallisation erfolgt vorzugsweise bei möglichst geringer Temperatur, wodurch auch die vom lokalen Schwingungselement bevorzugt erzeugbare Temperatur entsprechend klein sein kann. Die durch ein lokal konzentriertes Schwingungselement erzeugte Temperatur ist insbesondere kleiner als 800°C, vorzugsweise kleiner als 600°C, noch bevorzugter kleiner als 400°C, am bevorzugtesten kleiner als 200°C, am allerbevorzugtesten kleiner als 50°C.

Unabhängig von der verwendeten erfindungsgemäßen Ausführungsform kann der Substratstapel nach erfolgreicher Behandlung in einem externen, von der erfindungsgemäßen Ausführungsform getrennten Ofen wärmebehandelt werden. Die Wärmebehandlung ist jedoch ungeachtet der vorgenannten Verwendung eines getrennten Ofens auch in der Bondkammer oder in jedem anderen in der Prozesskette implementierten Moduls möglich. Insbesondere erfolgt erst durch die Wärmebehandlung die überwiegende Rekristallisation des Gefüges und damit der eigentliche permanente Bond. Die Rekristallisation erfolgt vorzugsweise bei möglichst geringer Temperatur. Die Temperatur im Ofen bzw. Bonder ist insbesondere kleiner als 800°C, vorzugsweise kleiner als 600°C, noch bevorzugter kleiner als 400°C, am bevorzugtesten kleiner als 200°C, am allerbevorzugtesten kleiner als 50°C.
- Figur 1a: eine schematische Querschnittsdarstellung eines beschichteten Substrats und eine Vergrößerung der Mikrostruktur der Beschichtung,
- Figur 1b: eine schematische Querschnittsdarstellung eines beschichteten Substrats und eine Vergrößerung der Mikrostruktur der Beschichtung nach einer Erhöhung der Versetzungsdichte,
- Figur 1c: eine schematische Querschnittsdarstellung zweier beschichteter Substrate nach einem Kontaktiervorgang und eine Vergrößerung der Mikrostruktur der Beschichtungen,
- Figur 1d: eine schematische Querschnittsdarstellung zweier beschichteter Substrate nach einem Bondvorgang und eine Vergrößerung einer über das Bondinterface erfolgten rekristallisierten Mikrostruktur,
- Figur 2a: eine schematische Querschnittsdarstellung einer ersten erfindungsgemäßen Ausführungsform, die direkt auf die Oberfläche eines Substrats wirkt und sofort zu einer Gefügeneubildung über die Bondgrenzfläche hinaus führt,
- Figur 2b: eine schematische Querschnittsdarstellung einer ersten erfindungsgemäßen Ausführungsform, die direkt auf die Oberfläche eines Substrats wirkt und noch zu keiner Gefügeneubildung über die Bondgrenzfläche hinaus führt,
- Figur 3a: eine schematische Querschnittsdarstellung einer zweiten erfindungsgemäßen Ausführungsform in einem ersten Zustand,
- Figur 3b: eine schematische Querschnittsdarstellung der zweiten erfindungsgemäßen Ausführungsform in einem zweiten Zustand,
- Figur 3c: eine schematische Querschnittsdarstellung der zweiten erfindungsgemäßen Ausführungsform in einem dritten Zustand,
- Figur 3d: eine schematische Darstellung eines Belastungsdiagrams der zweiten erfindungsgemäßen Ausführungsform,
- Figur 4a: eine schematische Querschnittsdarstellung einer dritten erfindungsgemäßen Ausführungsform in einem ersten Zustand,
- Figur 4b: eine schematische Querschnittsdarstellung der dritten erfindungsgemäßen Ausführungsform in einem zweiten Zustand,
- Figur 4c: eine schematische Querschnittsdarstellung der dritten erfindungsgemäßen Ausführungsform in einem dritten Zustand,
- Figur 4d: eine schematische Darstellung eines Belastungsdiagrams der dritten erfindungsgemäßen Ausführungsform,
- Figur 5: eine schematische, nicht maßstabsgetraue Darstellung einer ersten Ausführungsform einer erfindungsgemäßen Vorrichtung zur Erzeugung einer vollflächigen Biegeschwingung,
- Figur 6: eine schematische, nicht maßstabsgetraue Darstellung einer zweiten Ausführungsform einer erfindungsgemäßen Vorrichtung zur Erzeugung einer vollflächigen Biegeschwingung,
- Figur 7: eine schematische, nicht maßstabsgetraue Darstellung einer dritten Ausführungsform einer erfindungsgemäßen Vorrichtung zur Erzeugung einer vollflächigen Biegeschwingung,
- Figur 8: eine schematische, nicht maßstabsgetraue Darstellung einer vierten Ausführungsform einer erfindungsgemäßen Vorrichtung zur Erzeugung einer vollflächigen Scherschwingung,
- Figur 9: eine schematische, nicht maßstabsgetraue Darstellung einer fünften Ausführungsform einer erfindungsgemäßen Vorrichtung zur Erzeugung einer vollflächigen statischen Druckbeaufschlagung,
- Figur 10: eine schematische, nicht maßstabsgetraue Darstellung einer sechsten Ausführungsform einer erfindungsgemäßen Vorrichtung zur Erzeugung einer statischen Druckbeaufschlagung mit einer materialbezogenen Nachgiebigkeit des Probenhalters und
- Figur 11: eine schematische, nicht maßstabsgetraue Darstellung einer siebten Ausführungsform einer erfindungsgemäßen Vorrichtung zur Erzeugung einer statischen Druckbeaufschlagung mit einer konstruktionstechnischen Nachgiebigkeit des Probenhalters.

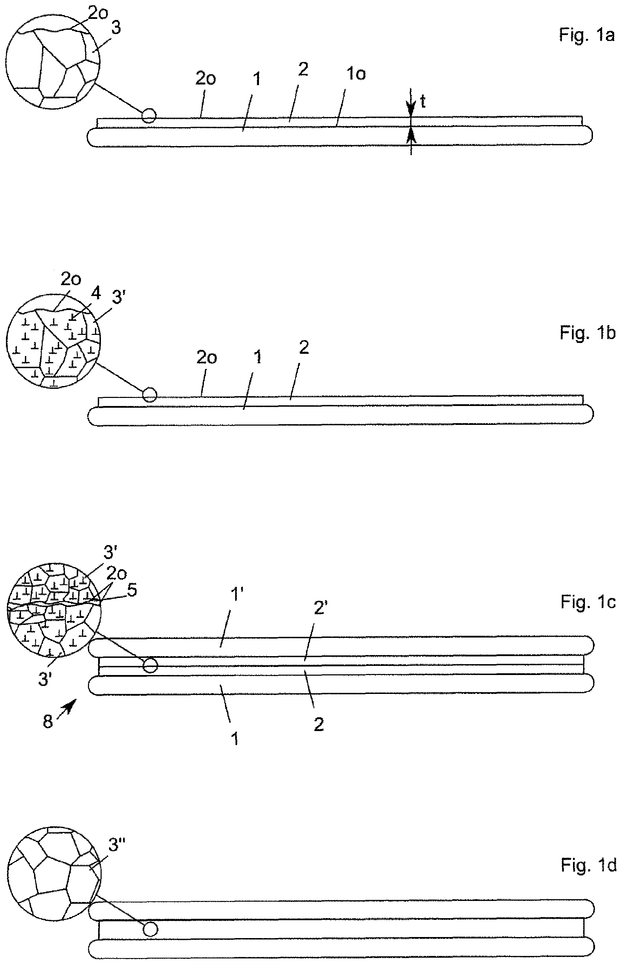

Die Figur 1a zeigt ein Substrat 1 mit einer auf eine Substratoberfläche 1o aufgebrachten Schicht 2, insbesondere einer Metallschicht, mit besonderem Vorzug einer Cu-Schicht. Die Vergrößerung stellt eine Mikrostruktur der Schicht 2 dar, die aus mehreren Körnern 3 besteht. Im Falle sehr geringer Schichtdicken t kann sich in Schichtdickenrichtung auch nur ein Korn 3 befinden. Die Schichtoberfläche 2o der Schicht 2 sowie die Substratoberfläche 1o sind im Allgemeinen mit einer nicht verschwindenden Rauheit versehen. Insbesondere ist die Rauheit erfindungsgemäß vernachlässigbar klein, mit besonderem Vorzug gar nicht vorhanden. Die Rauheit wird entweder als mittlere Rauheit, quadratische Rauheit oder als gemittelte Rauhtiefe angegeben. Die ermittelten Werte für die mittlere Rauheit, die quadratische Rauheit und die gemittelte Rauhtiefe unterscheiden sich im Allgemeinen für dieselbe Messstrecke bzw. Messfläche, liegen aber im gleichen Größenordnungsbereich. Daher sind die folgenden Zahlenwertebereiche für die Rauheit entweder als Werte für die mittlere Rauheit, die quadratische Rauheit oder für die gemittelte Rauhtiefe zu verstehen. Die Rauheit ist insbesondere kleiner als 100 µm, vorzugsweise kleiner als 1 µm, noch bevorzugter kleiner als 100 nm, am bevorzugtesten kleiner als 10nm, am allerbevorzugtesten kleiner als 1nm.

Durch ein beliebiges erfindungsgemäßes Verfahren wird nun in den Körnern 3 der Schicht 2 die Versetzungsdichte erhöht. Es entstehen mehrere Versetzungen 4. Die Körner 3 gehen dadurch in Körner 3' mit einer entsprechend hohen Versetzungsdichte über. Der Energiezustand der Körner 3' ist zumindest teilweise, vorzugsweise überwiegend, metastabil.

Zwei durch eine der erfindungsgemäßen Ausführungsformen präparierte Substrate 1, 1' mit Schichten 2, 2' werden nun miteinander kontaktiert bzw. gebondet. Bei einer Kontaktierung zweier Substrate mit funktionalen Einheiten kann eine vorherige Ausrichtung der Substrate zueinander notwendig sein. In einer besonderen Ausführungsform wird die Versetzungsdichte in den Schichten 2, 2' der Substrate 1, 1' vor und/oder nach der Kontaktierung erfindungsgemäß erhöht. In diesem Zustand befinden sich die beiden Schichten 2, 2' der Substrate 1, 1' in engem Kontakt miteinander und sind in einem metastabilen Zustand.

Figur 1d zeigt die erfolgreiche, erfindungsgemäße Gefügeneubildung durch Rekristallisation über eine Bondgrenzfläche (engl.: bond interface) 5 hinweg. Die Einleitung der Gefügeneubildung durch Rekristallisation erfolgt mit Vorzug durch eine, insbesondere leichte, Temperaturerhöhung. Die Temperaturerhöhung wird entweder durch eine der erfindungsgemäßen Ausführungsformen eingeleitet oder in einem externen, von der erfindungsgemäßen Ausführungsform getrennten, Ofen, insbesondere einem Durchlaufofen, durchgeführt. Der erfindungsgemäße Gedanke besteht vor allem darin, dass durch die erhöhte Versetzungsdichte der Körner 3' die Temperatur zur Gefügeneubildung extrem gesenkt werden kann. Die Temperatur beim Bonden ist insbesondere kleiner als 300°C, mit Vorzug kleiner als 200°C, mit großem Vorzug kleiner als 150°C, mit besonderem Vorzug kleiner als 100°C, am bevorzugtesten kleiner als 50°C. In einer besonderen Ausführungsform ist die mittlere Rauheit der Substratoberfläche 1o kleiner als 100µm, mit Vorzug kleiner als 10µm, mit größerem Vorzug kleiner als 1µm, mit größtem Vorzug kleiner als 100nm, mit allergrößtem Vorzug kleiner als 10nm.

Um die in den Figuren 1a-1d gezeigten Bondvorgang durchzuführen werden im Folgenden mehrere erfindungsgemäße Ausführungsformen präsentiert, welche die Erhöhung der Versetzungsdichte in den Körnern 3 bewerkstelligen könnten. Es wird nochmals erwähnt, dass die Erhöhung der Versetzungsdichte in jeder Schicht 2 eines jeden Substrats 1 vor und/oder nach der Kontaktierung der beiden Substrate erzeugt werden kann. Die Figuren 1a-1b zeigen die Erzeugung einer versetzungsreichen Schichten 2 vor dem eigentlichen Bondvorgang.

In einer ersten erfindungsgemäßen Ausführungsform wird eine entlang einer Substratrückseite 1r in einer Bewegungsrichtung bewegliche Schwingungseinrichtung 6 verwendet. Eine Kontaktfläche 6k der Schwingungseinrichtung 6 ist insbesondere kleiner als die Substratoberfläche 1o. Das Verhältnis zwischen der Kontaktfläche 6k und der Substratoberfläche 1o ist insbesondere kleiner als 1/2, mit Vorzug kleiner als 1/6, mit größerem Vorzug kleiner als 1/10, mit größtem Vorzug kleiner als 1/20, mit allergrößtem Vorzug kleiner als 1/100. Durch eine erfindungsgemäße extrem kleine Kontaktfläche 6k können extrem hohe punktförmige Kräfte auf den aus den an den Schichten 2, 2' kontaktierten Substraten 1, 1' gebildeten Substratstapel 8 und damit auf die Schichten 2 übertragen werden.

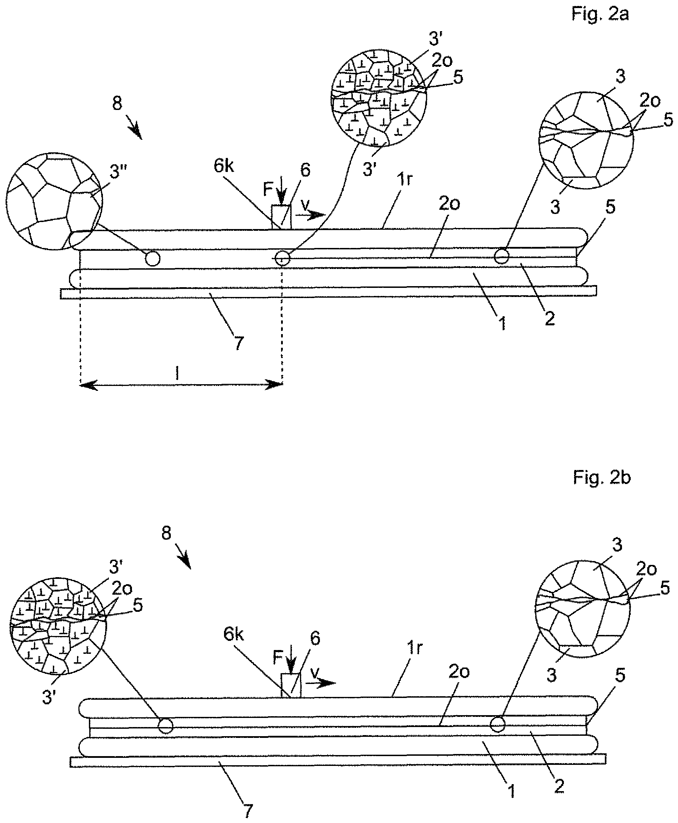

Die Schwingungseinrichtung 6 setzt den Substratstapel 8 lokal durch eine Vordruckkraft und/oder -spannung in Richtung eines Probenhalters 7 zur Aufnahme des Substratspatels 8 unter Druckspannung. Danach wird der positiven Vordruckspannung F eine periodische, mit Vorzug hochfrequente Schwingung überlagert. Die hochfrequente Schwingung führt zu einer lokalen Wechselbeanspruchung der Schichten 2, 2'. Durch die Wechselbeanspruchung werden die Schichten 2, 2' mit Vorzug einem Spannungszustand ausgesetzt, der erfindungsgemäß dazu geeignet ist, Versetzungen 4 in den Körnern 3 zu erzeugen. Die metallurgischen Voraussetzungen, wie beispielsweise Frank-Read Quellen, zur Erzeugung derartiger Versetzungen sind dem Fachmann bekannt. Die Schwingungseinrichtung 6 bewegt sich mit einer Geschwindigkeit V über den Substratstapel 8 und ist dabei immer mit einer Druckkraft f beaufschlagt. Durch die Schwingungseinrichtung 6 verbunden mit der Druckkraft f entsteht eine Temperatur von ca. 20-40% der Schmelztemperatur der Schichten 2, 2' und es kommt in der Folge zu einer Rekristallisation durch die eine kraftschlüssige Verbindung zum Substratstapel zustande kommt. In der Figur 2a wurde die Bondgrenzfläche 5 bereits entlang einer Strecke L geschlossen, da durch die Beaufschlagung der Schwingungseinrichtung 6 bereits genügend Versetzungen 4 in die Körner 3 und/oder Wärme in die Bondgrenzfläche 5 eingebracht wurden, um die Gefügeneubildung hervorzurufen.

In manchen Ausführungsformen könnte diese in-situ Gefügeneubildung unerwünscht sein und muss durch die korrekte Wahl der Prozessparameter verhindert werden, sodass ein metastabiles Gefüge mit Körnern 3' bis zur explizit durchgeführten Wärmebehandlung erhalten bleibt. Diese Situation wird in der Figur 2b dargestellt. Die Schwingungseinrichtung 6 erzeugt zwar Versetzungen 4 in den Gefügen der beiden Schichten 2, die dabei vorzugsweise, zumindest punktuell, verschweißt werden, die Rekristallisation, welche zur Gefügeneubildung über die Bondgrenzfläche 5 hinaus notwendig ist, findet zu diesem Zeitpunkt bevorzugt noch nicht statt.

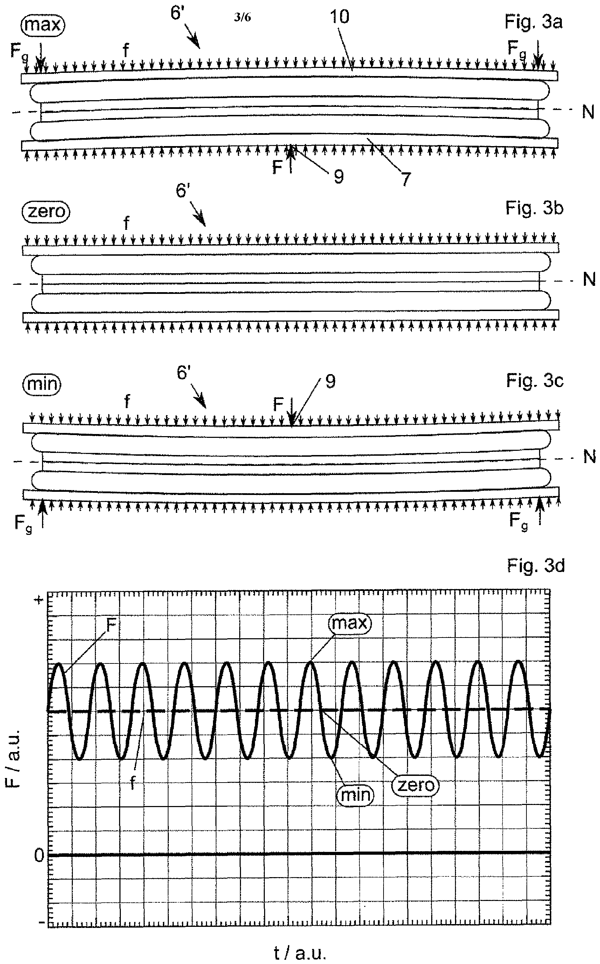

Die Figuren 3a-3c zeigen drei (globale) Schwingungszustände einer erfindungsgemäßen zweiten Ausführungsform mit einer Schwingungseinrichtung 6'. Diese erfindungsgemäße Schwingungseinrichtung 6' zeichnet sich dadurch aus, dass der Substratstapel 8 durch eine sich über die gesamte Bondgrenzfläche des Substratstapels 8 ausgedehnte, vollflächige Schwingung verformt wird. Der Substratstapel 8 wird dabei durch eine Flächenkraft f über die gesamte Substratoberfläche 1o vorgespannt und während der gesamten erfindungsgemäßen Schwingungsbelastung unter Druck gehalten.

Die erfindungsgemäße Ausführungsform weist mindestens einen unteren Probenhalter 7 auf, auf dem der Substratstapel 8 aufliegen kann. Mit besonderem Vorzug existiert eine gegenüberliegende Fixierung, beispielsweise eine Druckplatte 10.

Erfindungsgemäß wird die Kraft F, welche eine lokale Schwingungsüberlagerung zur Flächenkraft f erzeugt, an einem Schwingungsbereich 9 eingeleitet. Durch die Krafteinleitung in einem, insbesondere lokalen, vorzugsweise punktuellen, Schwingungsbereich 9 wird der Substratstapel in Richtung einer Normalen zur Substratoberfläche 1o ausgelenkt, wobei eine Gegenkraft Fg insbesondere durch je ein Lager oder je eine Halterung der Substrate 1, 1' oder des Probenhalters 7 und der Druckplatte 10 erzeugt wird. Der Schwingungsbereich 9 muss nicht zentrisch liegen, sondern kann an jeder beliebigen Position der Substratoberfläche 1o angreifen.

Die Figur 3d zeigt eine schematische Darstellung der sich zeitlich ändernden Kraftbeaufschlagung, welche sich aus der zeitlich konstanten Flächenkraft f (gestrichelte Linie) und der überlagerten, periodischen, insbesondere lokalen, Kraftbeaufschlagung F zusammensetzt. Erkennbar ist, dass die resultierende Kraft sich immer im positiven Druckbereich befindet, so dass die Substrate 1,1' immer aneinander gedrückt werden.

Die Krafteinbringung über den Schwingungsbereich 9 erfolgt insbesondere über Piezoelemente, hydraulische, pneumatische oder mechanisch gesteuerte Stifte, welche dafür sorgen, dass der Probenhalter 7 und/oder die Druckplatte 10 und damit der Substratstapel 8 auf Grund der nicht mit der Schwingungskraft F kongruenten und/oder fluchtenden Gegenkraft Fg entsprechend verformt, insbesondere gebogen werden.

Die Biegung erzeugt in den Schichten 2, 2' einen Spannungszustand und dadurch die erhöhte Versetzungsdichte. Anstatt des Probenhalters 7 und/oder der Druckplatte 10 wären auch kreisförmige Ringlager denkbar, auf denen der Substratstapel 8 gelagert wird. Dadurch sind die Substratoberflächen 1o direkt für die elektrischen, mechanischen, pneumatischen oder hydraulischen Schwingelemente zugänglich. Denkbar wäre sogar eine Ausführungsform, bei der das kreisförmige Auflager selbst aus einem Piezomaterial gefertigt wird. Danach erfolgt eine Fixierung des Substratstapels auf dem kreisförmigen Auflager. Durch die Piezoschwingungen des kreisförmigen Auflagers wird der Substratstapel 8 entsprechend in Resonanz gebracht und schwingt unter den am Rand definierten Anfangs- und Randbedingungen. Durch diese spezielle Ausführungsform kann auf ein elektrisches, mechanisches, pneumatisches oder hydraulisches Verformungselement im Zentrum verzichtet werden.

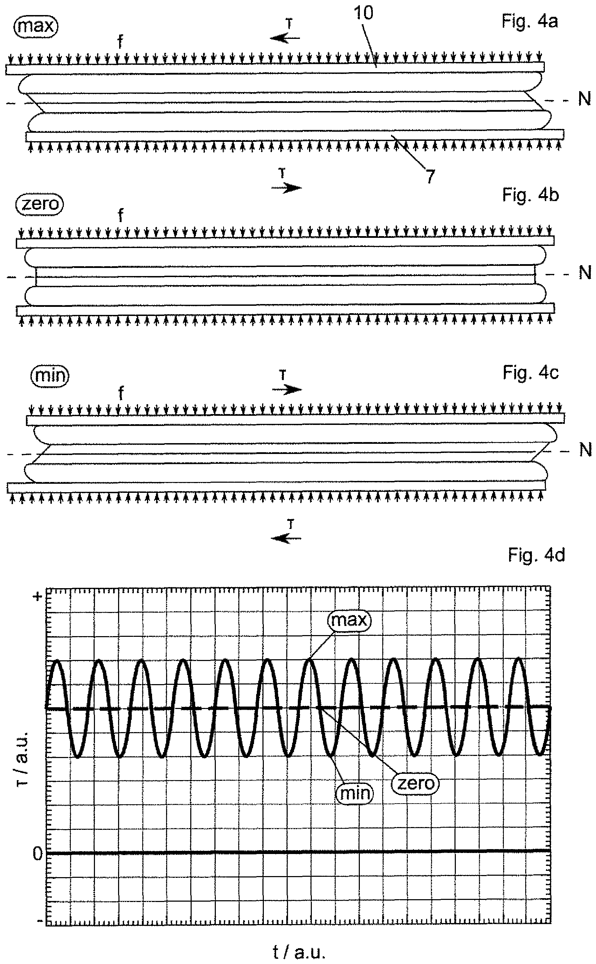

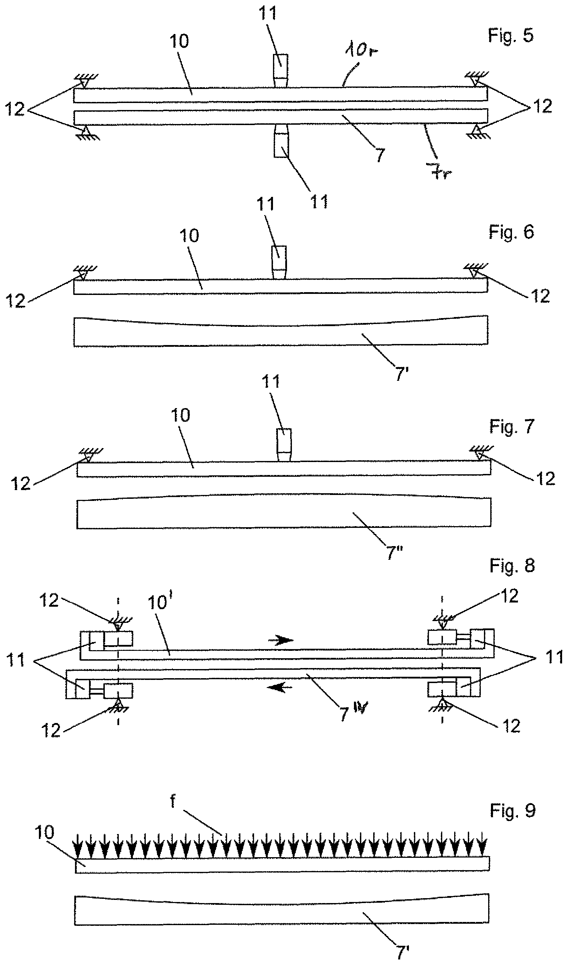

Die Figuren 4a-4d zeigen eine analoge Ausführungsform mit dem Unterschied einer an dem Substratstapel 8 angreifenden Scherbeanspruchung (Scherspannung) T. Die Scherung des Substratstapels 8 in den Figuren 4a und 4c ist übertrieben dargestellt. Der Scherwinkel beträgt nur einige wenige Grad. Der Scherwinkel ist insbesondere kleiner als 10°, mit Vorzug kleiner als 1°, mit größerem Vorzug kleiner als 0.1°, mit größtem Vorzug kleiner als 0.01°, mit allergrößtem Vorzug kleiner als 0.001°. Zur erfindungsgemäßen Scherung des Substratstapels 8 ist mit Vorzug eine vollflächige Kontaktierung der Substratrückseite 1r, insbesondere mit einem Probenhalter 7"' und/oder einer Druckplatte 10' gemäß Figur 8 vorgesehen.

Die Figur 5 zeigt eine erste erfindungsgemäße Ausführungsform zur Erzeugung einer vollflächigen Biegeschwingung, bestehend aus einem, insbesondere im Ruhezustand ebenen, Probenhalter 7 zur Aufnahme und Halterung/Fixierung des Substratstapels 8 und einer, insbesondere im Ruhezustand ebenen, Druckplatte 10. Der Probenhalter 7 und die Druckplatte 10 sind an ihren Rückseiten (7r, 10r) und/oder Peripherien über jeweils mindestens drei punktuelle Festlager 12 oder einem einzigen, radialsymmetrischen, vollumfänglichen Festlager, fixiert. Zwei insbesondere als Piezoelemente ausgebildete Schwingelemente, , 11 sind in der Lage, den Probenhalter 7 und die Druckplatte 10 normal zu ihrer Oberfläche auszulenken und den zwischen ihnen fixierten Substratstapel 8, insbesondere zyklisch, auf Biegung zu beanspruchen. Insbesondere kann die erfindungsgemäße Ausführungsform auch eine Vordruckkraft f oder Vorspannung aufbringen, vorzugsweise durch Bewegung eines oder beider Schwingelemente 11.

Die Figur 6 zeigt eine zweite erfindungsgemäße Ausführungsform zur Erzeugung einer vollflächigen Biegeschwingung, bestehend aus einem Probenhalter 7' und einer, im Ruhezustand ebenen, Druckplatte 10. Der Probenhalter 7' ist an seiner Aufnahmeseite 7o konkav geformt. Die Druckplatte 10 ist analog zur ersten Ausführungsform gemäß Figur 5 ausgebildet. Der Substratstapel 8 wird hier durch ein einziges, oberes Schwungelement 11 in die statische, konkave Form des Probenhalters 7' gedrückt. Insbesondere kann die erfindungsgemäße Ausführungsform auch eine Vordruckkraft f oder Vorspannung aufbringen, vorzugsweise durch Bewegung des Schwingelements 11 in Richtung des Probenhalters 7'. Die Vordruckkraft f wird vorzugsweise aufgebracht, um den Substratstapel 8 in die konkave Form des Probenhalters 7' zu drücken und ihn in dieser gekrümmten Form konstant unter Druck zu beanspruchen. Danach erfolgt vorzugsweise die erfindungsgemäße Überlagerung der schwingenden Beanspruchung durch das Schwingelement 11.

Die Figur 7 zeigt eine dritte erfindungsgemäße Ausführungsform zur Erzeugung einer vollflächigen Biegeschwingung mit einem konvexen Probenhalter 7". Im übrigen entspricht der Aufbau und die Funktion der zweiten Ausführungsform gemäß Figur 6.
Die Figur 8 zeigt eine vierte erfindungsgemäße Ausführungsform zur Erzeugung einer vollflächigen Scherbeanspruchung (siehe Figur 4a bis 4c) Der Substratstapel 8 wird zwischen dem ebenen Probenhalter 7'^{v} und der ebenen Druckplatte 10' auf Druck fixiert. Danach erfolgt eine Scherung des Substratstapels 8 durch gegenläufige, schwingende Bewegung des Probenhalters 7'^{v} und der Druckplatte 10 zueinander. Die Bewegung erfolgt mittels Schwingelementen 11', die am Seitenumfang des Probenhalters 7'^{v} und der Druckplatte 10' angeordnet sind. Die Festlager 12 dienen als Fixpunkte für die, insbesondere als Piezoelemente ausgebildeten, Schwingelemente 11', die jeweils zwischen jedem Festlager 12 und dem Probenhalter 7'^{v} der Druckplatte 10' angeordnet sind.

Die Figur 9 zeigt eine vierte erfindungsgemäße Ausführungsform mit einer Druckplatte 10 und einem statischen, konkav gekrümmten Probenhalter 7' analog Figur 6. Eine, insbesondere als Flächenlast ausgebildete, Vordrucklast f wird auf die Druckplatte 10 aufgebracht. Die Druckplatte 10 drückt den Substratstapel 8 (nicht eingezeichnet) an den konkaven Probenhalter 7' und erzeugt dadurch, in den miteinander zu verbondeten Oberflächen, einen metastabilen Zustand, insbesondere eine erhöhte Versetzungsdichte. Es kann anstatt des konkav ausgebildeten Probenhalter 7' genauso der konvex ausgebildete Probenhalter 7" verwendet werden, wie er in Fig. 7 dargestellt ist.

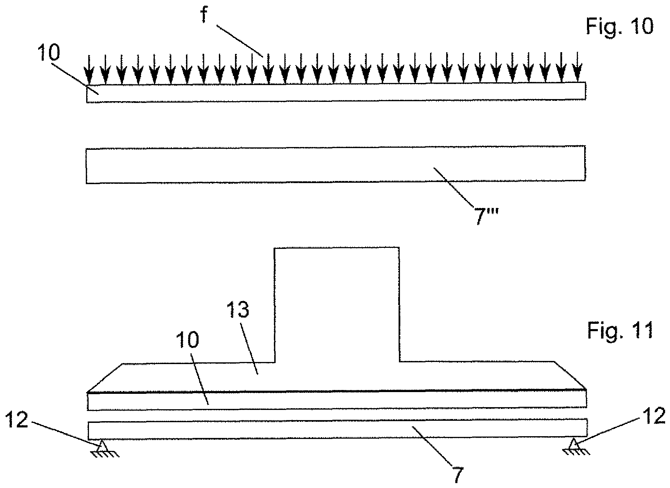

Insbesondere ist auch die Verwendung eines Probenhalters 7"' gemäß Figur 10 möglich, der aus einem derartig elastischen Material besteht, dass er erst durch die über die Druckplatte 10 aufgebrachte Vordruckkraft f (in diesem speziellen Fall ist das insbesondere die vollflächige Bondkraft) in eine konkave Form gebracht wird. Der Probenhalter 7'" verhält sich insbesondere elastisch, so dass er geht nach Entfernung der Vordruckkraft f, insbesondere eine Flächenkraft, wieder in seine ursprüngliche Ausgangsposition zurückkehrt.

Ein erfindungsgemäßer Aspekt in einer derartigen Ausführungsform besteht insbesondere in der Haftreibung zwischen den vor dem erfindungsgemäßen Vorgang noch nicht miteinander verbondeten Oberflächen, während die Vordruckkraft f auf den Substratstapel drückt und diesen, auf Grund der Elastizität des Materials des Probenhalters 7'" in diesen drückt. Der Probenhalter 7'" gibt also auf Grund materialspezifischer Parameter wie dem E-Modul nach. Insbesondere wird der Probenhalter 7'" elastisch konkav verformt, wenn der E-Modul des Probenhalters 7"' sich vom Zentrum zum Rand hin erhöht, der Probenhalter 7"' also gemäß einer bevorzugten Ausführungsform über einen E-Modulgradienten verfügt und/oder die Flächenkraft f keine Gleichlast, sondern eine vom Zentrum zum Rand abnehmende Flächenlast darstellt.
Figur 11 zeigt eine besonders bevorzugte Ausführungsform eines auf Festlagern 12 fixierten Probenhalters 7. Der Probenhalter 7 kann entweder direkt auf den Festlagern 12 aufliegen oder, bevorzugter, auf Konstruktionselementen aufliegen, welche sich zwischen dem Probenhalter 7 und den Festlagern 12 befinden. Die Figur 11 stellt daher nur eine sehr schematische Skizze dar. Der erfindungsgemäße Gedanke besteht ausschließlich darin, dass der den Substratstapel 8 aufnehmende Probenhalter 7 so gelagert wird, dass die Kraft bei einer Druckbeaufschlagung über die Festlager 12 abfließt und der Probenhalter 7 zentrisch durchgebogen wird.

Bei den Festlagern 12 handelt es sich insbesondere um radialsymmetrische, vollumfängliche, sich in der Position der äußeren Peripherie des Probenhalters 7 befindliche Festlager. Die dem Probenhalter 7 gegenüberliegende Druckplatte 10 wird vorzugsweise an einem Druckkolben 13, insbesondere dem Druckkolben 13 eines Bonders, fixiert. Der zwischen der Druckplatte 10 und dem Probenhalter 7 positionierte Substratstapel 8 (nicht eingezeichnet) wird durch eine relative Annäherung der Druckplatte 10 und des Probenhalters 7, insbesondere durch eine Bewegung des Druckkolbens 13, mit Druck beaufschlagt. Der Druckkolben 13 ist dabei vorzugsweise so gefertigt, dass eine zentrische Punktkraft während der fortschreitenden Druckbeaufschlagung in eine, homogene Flächenkraft umgewandelt wird. Denkbar ist allerdings auch eine Übertragung einer zentrischen Punktkraft über den Druckkolben 13 und die Druckplatte 10 auf den Substratstapel 8. Unter dieser Druckbelastung biegt sich der Probenhalter 7 und damit auch der Substratstapel 8, zentrisch und damit konkav durch, und wird peripher von den Festlagern 12 gestützt. Im Gegensatz zur erfindungsgemäßen Ausführungsform in Fig. 10, erfolgt die konkave Durchbiegung dabei nicht auf Grund materialspezifischer Parameter wie einem E-Modul bzw. einem E-Modulgradienten, sondern auf Grund konstruktionstechnischer Merkmale, insbesondere einer ausschließlich peripheren, insbesondere vollumfänglichen, Abstützung des Probenhalters 7 durch die Festlager 12.

Durch die genannte erfindungsgemäße Ausführungsform wird ein Substratstapel 8 und damit die einzelnen Substrate 1,1' wiederum derart zueinander verschoben, dass durch eine Belastung, insbesondere eine Reibung zwischen den Schichten 2, 2', eine erfindungsgemäßer Effekt der Erzeugung eines metastabilen Gleichgewichts, insbesondere eines Gefüges mit erhöhter Versetzungsstruktur, erzeugt wird, der in weiterer Folge zu einer optimaleren Verbindung beider Substrate 1, 1' über die Schichten 2, 2' führt.

### Verfahren und Vorrichtung zum permanenten Bonden

### Bezugszeichenliste

- 1, 1': Substrate
- 1o: Substratoberfläche
- 1r: Substratrückseite
- 2, 2': Schichten
- 2o: Schichtoberfläche
- 3: Korn
- 3': Metastabiles Korn mit hoher Versetzungsdichte
- 4: Versetzung
- 5: Bondgrenzfläche
- 6, 6': Schwingungseinrichtung
- 6k: Kontaktfläche
- 7, 7', 7" ; 7"', 7'^{v}: Probenhalter
- 7r: Rückseiten
- 8: Substratstapel
- 9: Krafteinsatzpunkt
- 10, 10': Druckplatte
- 10r: Rückseiten
- 11: Schwingelement, insbesondere Piezoelement(e)
- 12: Festlager
- 13: Druckkolben
- T: Schichtdicke
- v: Bewegungsvorrichtung/Geschwindigkeit
- f: Vordruckkraft
- F: Schwingungskraft
- L: Strecke
- T: Scherbeanspruchung
- Fg: Gegenkraft

## Patentansprüche

1. Verfahren zum permanenten Bonden einer ersten Schicht (2) eines ersten Substrats (1) mit einer zweiten Schicht (2') eines zweiten Substrats (1') an einer Bondgrenzfläche (5), wobei eine Versetzungsdichte einer Versetzung (4) der ersten und/oder zweiten Schicht (2, 2') zumindest im Bereich der Bondgrenzfläche (5) vor und/oder während des Bondens erhöht wird, **dadurch gekennzeichnet, dass** der Substratstapel (8) auf einem Probenhalter (7, 7', 7", 7"', 7'^{v}) gelagert wird, der eine Verformung der ersten und/oder zweiten Schicht zulässt, wobei der Probenhalter (7, 7', 7", 7"', 7") und/oder eine Druckplatte (10,10') bei einer vollflächigen Druckbeaufschlagung des Substratstapels (8) zum Bonden der Schichten (2,2') konkav und/oder konvex verformt wird, wobei die Verformung des Probenhalters (7, 7', 7", 7"', 7'^{v} und/oder der Druckplatte (10,10') bei der Druckbeaufschlagung zur Erhöhung der Versetzungsdichte der Versetzung (4) zumindest im Bereich der Bondgrenzfläche (5) führt.

2. Verfahren nach Anspruch 1, bei dem die Versetzungsdichte durch mindestens eine Schwingung, vorzugsweise mehrere Schwingungen, erhöht wird, wobei die mindestens eine Schwingung vorzugsweise durch eine im Ultraschallbereich arbeitende Schwingungseinrichtung (6, 6'), insbesondere lokal, eingebracht wird.

3. Verfahren nach einem der Ansprüche 1 oder 2, bei dem eine Bondtemperatur beim Bonden maximal 300 °C, insbesondere maximal 200 °C, vorzugsweise maximal 150 °C, bevorzugter maximal 100 °C, noch bevorzugter maximal 50 °C, beträgt.

4. Verfahren nach einem der vorhergehenden Ansprüche, bei dem die ersten, insbesondere disktrete, und/oder zweite, insbesondere diskrete, Schicht (2, 2') metallisch, insbesondere Cu, ist und das erste und/oder zweite Substrat (1, 1') ein Halbleiter ist.

5. Verfahren nach einem der vorhergehenden Ansprüche, bei dem eine quer zur Bondgrenzfläche (5) wirkende Druckkraft f auf die Substrate (1, 1') durch die Schwingungen überlagert ist, insbesondere mit einer minimalen resultierenden Kraft größer 0.

6. Vorrichtung zum permanenten Bonden einer ersten Schicht (2) eines ersten Substrats (1) mit einer zweiten Schicht (2') eines zweiten Substrats (1') an einer Bondgrenzfläche (5) mit:
- einem Probenhalter (7, 7', 7", 7"', 7'^{v} zur Aufnahme des ersten Substrats (1), wobei der Substratstapel (8) auf dem Probenhalter (7, 7', 7", 7"', 7'^{v} lagerbar ist, und
- einer Druckplatte (10, 10') zur Beaufschlagung der Substrate (1, 1'), die geeignet ist, eine Versetzungsdichte einer Versetzung (4) der ersten und/oder zweiten Schicht (2, 2') zumindest im Bereich einer Bondgrenzfläche (5) zu erhöhen, **dadurch gekennzeichnet dass** der Probenhalter (7, 7', 7", 7"', 7'^{v}) eine Verformung der ersten und/oder zweiten Schicht zulassend ausgebildet ist, wobei der Probenhalter (7, 7', 7", 7"', 7'^{v}) und/oder die Druckplatte (10, 10') bei einer vollflächigen Druckbeaufschlagung des Substratstapels (8) zum Bonden der Schichten (2,2') konkav und/oder konvex verformbar ist, wobei die Verformung des Probenhalters (7, 7', 7", 7"', 7'^{v}) und/oder der Druckplatte (10,10') bei der Druckbeaufschlagung zur Erhöhung der Versetzungsdichte der Versetzung (4) zumindest im Bereich der Bondgrenzfläche (5) führt.

7. Vorrichtung nach Anspruch 6, bei der der Probenhalter (7, 7', 7", 7"', 7'^{v} und/oder die Druckplatte (10, 10') an ihren Rückseiten (7r, 10r) mittels Festlagern (12) abgestützt sind.

8. Vorrichtung nach Anspruch 6 oder 7, bei der die Beaufschlagung mit mindestens einer Schwingung, vorzugsweise mehreren Schwingungen erfolgt.

## Claims

1. A method for permanent bonding of a first layer (2) of a first substrate (1) to a second layer (2') of a second substrate (1') at a bond interface (5), wherein a dislocation density of a dislocation (4) of the first and/or second layer (2, 2') is increased at least in the region of the bond interface (5) before and/or during the bonding, **characterized in that** the substrate (8) stack is supported on a sample holder (7, 7', 7", 7"', 7'^{v}), which permits a deformation of the first and/or second layer, wherein the sample holder (7, 7', 7", 7"', 7'^{v}) and/or a pressure plate (10, 10') are deformed in a concave and/or convex manner with an all-over pressure loading of the substrate stack (8) for bonding the layers (2, 2'), wherein the deformation of the sample holder (7, 7', 7", 7"', 7'^{v}) and/or of the pressure plate (10, 10') with the pressure loading leads to the increase in the dislocation density of the dislocation (4) at least in the region of the bond interface (5).

2. The method as claimed in claim 1, wherein the dislocation density is increased by at least one oscillation, preferably a plurality of oscillations, wherein the at least one oscillation is delivered, in particular locally, preferably by an oscillation apparatus (6, 6') which operates in the ultrasonic range.

3. The method as claimed in one of claims 1 or 2, wherein a bond temperature during bonding amounts to a maximum 300°C, in particular a maximum 200°C, preferably a maximum 150°C, more preferably a maximum 100°C, still more preferably a maximum 50°C.

4. The method as claimed in one of the preceding claims, wherein the first, in particular discrete and/or second, in particular discrete layer (2, 2') is metallic, in particular Cu, and the first and/or second substrate (1, 1') is a semiconductor.

5. The method as claimed in one of the preceding claims, wherein a compressive force f acting transversely to the bond interface (5) is superimposed on the substrates (1, 1') by the oscillations, in particular with a minimal resulting force greater than 0.

6. A device for permanent bonding of a first layer (2) of a first substrate (1) to a second layer (2') of a second substrate (1') at a bond interface (5), with:
- a sample holder (7, 7', 7", 7"' 7'^{v}) for receiving the first substrate (1), wherein the substrate stack (8) can be supported on the sample holder (7, 7', 7", 7'", 7'^{v}), and
- a pressure plate (10, 10') for loading the substrate (1, 1') which is suitable for increasing the dislocation density of a dislocation (4) of the first and/or second layer (2, 2') at least in the region of a bond interface (5),
**characterized in that** the sample holder (7, 7', 7", 7"', 7'^{V}) is constituted so as to permit the deformation of the first and/or second layer, wherein the sample holder (7, 7', 7", 7"', 7'^{v}) and/or a pressure plate (10, 10') can be deformed in a concave and/or convex manner with an all-over pressure loading of the substrate stack (8) for bonding the layers (2, 2'), wherein the deformation of the sample holder (7, 7', 7", 7"', 7'^{v}) and/or of the pressure plate (10, 10') with the pressure loading leads to the increase in the dislocation density of the dislocation (4) at least in the region of the bond interface (5).

7. The device as claimed in claim 6, wherein the sample holder (7, 7', 7", 7"', 7'^{v}) and/or the pressure plate (10, 10') are supported on their rear sides (7r, 10r) by means of locating bearings (12).

8. The device as claimed in claim 6 or 7, wherein the loading takes place with at least one oscillation, preferably a plurality of oscillations.

## Revendications

1. Procédé destiné à la liaison permanente d'une première couche (2) d'un premier substrat (1) à une seconde couche (2') d'un second substrat (1') sur une interface de liaison (5), dans lequel une densité d'un déplacement (4) de la première et/ou seconde couche (2, 2') est augmentée au moins dans la région de l'interface de liaison (5) avant et/ou pendant la liaison, **caractérisé en ce que** la pile de substrats (8) est disposée sur un porte-échantillon (7, 7', 7", 7'", 7'^{v} qui permet une déformation de la première et/ou seconde couche, dans lequel le porte-échantillon (7, 7', 7", 7"', 7'^{v}) et/ou une plaque de pression (10, 10') est/sont déformé(e)(s) de manière concave et/ou convexe lors d'une sollicitation en pression sur toute la surface de la pile de substrats (8) pour lier les couches (2, 2'), dans lequel la déformation du porte-échantillon (7, 7', 7", 7"' 7'^{v}) et/ou de la plaque de pression (10, 10') lors de la sollicitation en pression conduit à une augmentation de la densité du déplacement (4) au moins au niveau de l'interface de liaison (5).

2. Procédé selon la revendication 1, dans lequel la densité de déplacement est augmentée par au moins une oscillation, de préférence plusieurs oscillations, dans lequel l'au moins une oscillation est introduite, en particulier localement, par un dispositif d'oscillation (6, 6') fonctionnant dans la plage des ultrasons.

3. Procédé selon l'une des revendications 1 ou 2, dans lequel une température lors de la liaison est de maximum 300°C, en particulier de maximum 200°C, de préférence de maximum 150°C, de manière plus préférée de maximum 100°C, de manière encore plus préférée de maximum 50°C.

4. Procédé selon l'une des revendications précédentes, dans lequel la première couche, en particulier discrète, et/ou seconde couche (2, 2'), en particulier discrète, est métallique, en particulier en Cu, et le premier et/ou second substrat (1, 1') est un semi-conducteur.

5. Procédé selon l'une des revendications précédentes, dans lequel une force de compression f qui agit transversalement à l'interface de liaison (5) est superposée sur les substrats (1, 1') par les oscillations, en particulier avec une force résultante minimale supérieure à 0.

6. Dispositif destiné à la liaison permanente d'une première couche (2) d'un premier substrat (1) à une seconde couche (2') d'un second substrat (1') sur une interface de liaison (5), comprenant :
- un porte-échantillon (7, 7', 7", 7"', 7'^{v}) pour recevoir le premier substrat (1), dans lequel la pile de substrats (8) peut être disposée sur le porte-échantillon (7, 7', 7", 7"', 7'^{v}), et
- une plaque de pression (10, 10') pour solliciter les substrats (1, 1') qui est appropriée pour augmenter une densité d'un déplacement (4) de la première et/ou seconde couche (2, 2') au moins dans la région d'une interface de liaison (5),
**caractérisé en ce que** le porte-échantillon (7, 7', 7", 7"', 7'^{v}) est conçu pour permettre une déformation de la première et/ou seconde couche, dans lequel le porte-échantillon (7, 7', 7", 7"', 7'^{v} et/ou la plaque de pression (10, 10') peu(ven)t être déformé(s) de manière concave et/ou convexe lors d'une sollicitation en pression sur toute la surface de la pile de substrats (8) pour lier les couches (2, 2'), dans lequel la déformation du porte-échantillon (7, 7', 7" 7"', 7'^{v}) et/ou de la plaque de pression (10, 10') lors de la sollicitation en pression conduit à l'augmentation de la densité du déplacement (4) au moins au niveau de l'interface de liaison (5).

7. Dispositif selon la revendication 6, dans lequel le porte-échantillon (7, 7', 7", 7"', 7'^{v} et/ou la plaque de pression (10, 10') est/sont appuyé(e)(s) sur leurs dos (7r, 10r) au moyen de fixations (12).

8. Dispositif selon la revendication 6 ou 7, dans lequel la sollicitation est effectuée par au moins une oscillation, de préférence plusieurs oscillations.
